# EUROPÄISCHE PATENTSCHRIFT

(11) **EP 0 931 185 B1**
(45) Veröffentlichungstag und Bekanntmachung des Hinweises auf die Patenterteilung: **11.04.2001**
(21) Anmeldenummer: 97934476.9
(22) Anmeldetag: 17.07.1997
(51) Int. Cl.: C30B 15/14, C30B 15/10, C30B 15/00

(54) **VERFAHREN ZUM ZIEHEN VON EINKRISTALLEN**
PROCESS FOR GROWING MONOCRYSTALS
PROCEDE POUR LE TIRAGE DE MONOCRISTAUX

(30) Priorität: 20.09.1996 DE 19638563
(43) Veröffentlichungstag der Anmeldung: 28.07.1999
(73) Patentinhaber: Forschungszentrum Karlsruhe GmbH, 76133 Karlsruhe (DE)
(72) Erfinder: BARLEON, Leopold, D-76356 Weingarten (DE)
(86) Internationale Anmeldenummer: EP9703822
(87) Internationale Veröffentlichungsnummer: WO9812365

(56) Entgegenhaltungen:
- EP-A- 0 454 151
- EP-A- 0 634 504
- DE-A- 2 016 101
- DE-A- 2 416 489
- FR-A- 1 203 822
- GB-A- 2 159 728
- US-A- 4 548 670

## Beschreibung

Die Erfindung betrifft ein Verfahren zum Ziehen von Einkristallen nach dem Oberbegriff des Patentanspruchs 1.

Ein Verfahren der gattungsgemäßen Art ist aus D. T. J. Hurle: Handbook of Crystalgrowth 2a Basic Technics, North Holland (1994) S. 102 ff. bekannt.

In einem Tiegel aus Quarz wird eine begrenzte Menge an Silizium erschmolzen und die Schmelze wird aufrecht erhalten. Der Tiegel ruht in einer Matritze aus Graphit. Die Heizung erfolgt über Strahlung von Heizstäben auf den Graphit, vom Graphit auf den Quarztiegel und vom Quarztiegel durch Wärmeleitung an das Silizium. Aus der Siliziumschmelze wird in üblicher Weise der Einkristall gezogen.

Ein gravierender Nachteil bei diesem Verfahren besteht darin, daß der Tiegel heißer sein muß als die Schmelze. Die Übertemperatur des Tiegels wird umso größer je größer der Durchmesser des Einkristalls und damit des Schmelzbades ist. Mit größer werdendem Schmelzbaddurchmesser steigt der durch den Quarz fließende Wärmestrom und damit das treibende Temperaturgefälle Quarztiegel - Schmelze. Dadurch wird der Tiegel weich und es kommt zu einer Reaktion zwischen Tiegel und Schmelze, wobei als Verunreinigung Sauerstoff und/oder Tiegelmaterial an die Schmelze abgegeben wird.

Aus der DE-A-24 16 489 ist eine Vorrichtung zur Züchtung von Einkristallen bekannt, bei der polykristallines Silicium durch einen Induktor und einen ringförmigen Strahlungsheizer über der Strinfläche des Kristalls so aufgeschmolzen wird, daß sich eine Selbsttiegelung bildet.

Aufgabe der Erfindung ist es, ein Verfahren der gattungsgemäßen Art so auszugestalten, daß beim Schmelzvorgang keine zusätzlichen Verunreinigungen entstehen.

Gelöst wird diese Aufgabe durch die kennzeichnenden Merkmale des Patentanspruchs 1. Die Unteransprüche beschreiben vorteilhafte Ausgestaltungen des Verfahrens.

Das erfindungsgemäße Verfahren zeichnet sich durch folgende besondere Vorteile aus.

Durch die induktive Heizung wird die Energie direkt dem Volumen zugeführt, wobei die Randzone kälter bleibt als das Innere des Schmelzbades. Dadurch werden Verunreinigungen von Außen vermieden und Strahlungsverluste minimiert. Es ist auch möglich den Prozess kontinuierlich zu führen.

Die Erfindung wird im folgenden anhand zweier Ausführungsbeispiele mit Hilfe der Figuren näher erläutert.

Dabei zeigen die Fig. 1 und 2 verschiedene Möglichkeiten zum Hochheizen des Materials. Die Fig. 3 und 4 zeigen schematisch Vorrichtungen zur Durchführung des erfindungsgemäßen Verfahrens und die Fig. 5 und 6 den Temperaturverlauf im Material bei verschiedenen Frequenzen der Induktionsheizung.

Mit dem Verfahren können Einkristalle aus Halbleitermaterialien wie Silizium, Germanium und Galliumarsenid und aus Ionensalzen gezogen werden.

Als Ausgangsmaterial kommen polykristalline Festkörper (erstarrte Schmelzen oder durch Kristallisation aus der Dampfphase erzeugt) oder Sinterkörper und Preßlinge in Frage.

Die beiden Ausführungsbeispiele unterscheiden sich durch die Wärmeleitfähigkeit des Ausgangsmaterials.

Bei der Verwendung von polykristallinen Festkörpern mit hoher Wärmeleitfähigkeit gibt es drei Aufheizmöglichkeiten für die erste Aufheizstufe zur Erhöhung der elektrischen Leitfähigkeit.

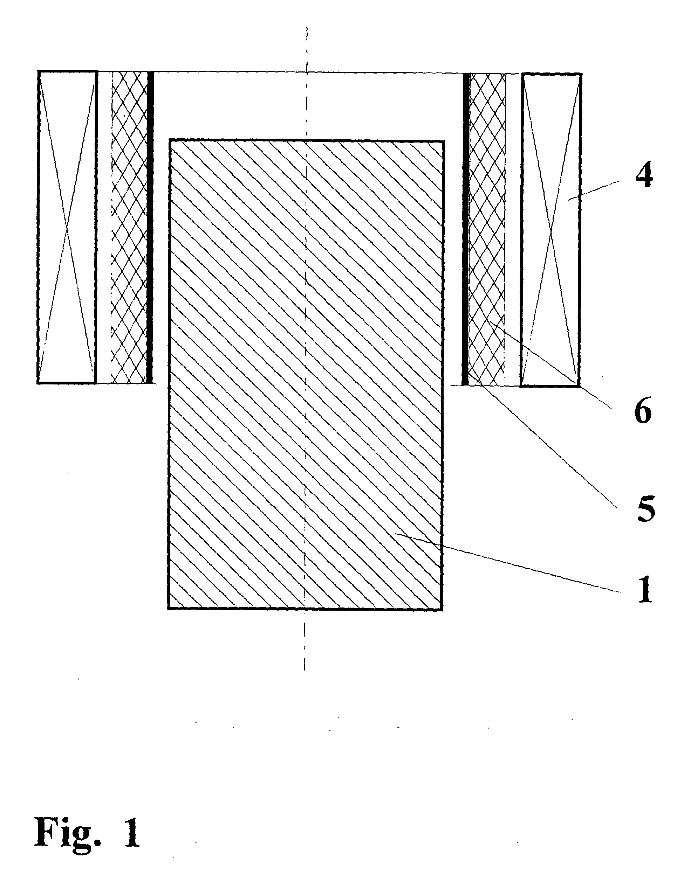

Fig. 1 zeigt das Prinzip der Aufheizung des polykristallinen Festkörpers durch Wärmestrahlung.

Der Festkörper 1 wird mit einer Wärmestrahlungsquelle umgeben. Diese Strahlungsquelle 5 kann entweder eine Anordnung von am Umfang verteilten, elektrisch beheizten Stäben sein, die nach dem Aufheizvorgang nach unten weggefahren oder entfernt werden oder ein einfacher Strahlungsschirm aus einem hochwarmfesten Werkstoff, der mit Hilfe einer Induktionsspule 4 auf einer Temperatur nahe dem Schmelzpunkt des zu erschmelzenden Materials gehalten wird. Dieser Schirm heizt über Wärmestrahlung den Festkörper mit einer Leistung von bis zu ca. 40 KW auf eine Temperatur auf, die ausreichend ist, die elektrische Leitfähigkeit des polykristallinen Festkörpers soweit zu erhöhen, daß ein angelegtes Induktionsfeld genügend viel Energie in den Körper einbringen kann, um ihn zum Erschmelzen zu bringen. Die Wärmeverluste des Heizschirmes nach außen können durch eine thermische, elektrisch nicht leitende Isolierung 6 stark reduziert werden. Diese Wärmeisolierung wird nach Beendigung des Aufheizvorganges zusammen mit dem Heizschirm nach unten verschoben oder entfernt.

Wird eine Sendefrequenz der Induktionsspule gewählt, die hoch genug ist (für Silizium größer 200 KHz) auch in dem kalten Festkörper mehr Energie zu entbinden als über seine Oberfläche durch Abstrahlung verloren geht, so kann auf die Aufheizphase mittels Wärmestrahlung verzichtet werden. Allerdings muß in diesem Fall nach Erreichen einer Temperatur, die etwa 100 K unter dem Schmelzpunkt des Festkörpers liegt entweder die Spule 4 durch eine Arbeitsspule ersetzt werden, oder es muß an der Spule 4 die Frequenz von > 200 KHz auf < 10 KHz heruntergesetzt werden.

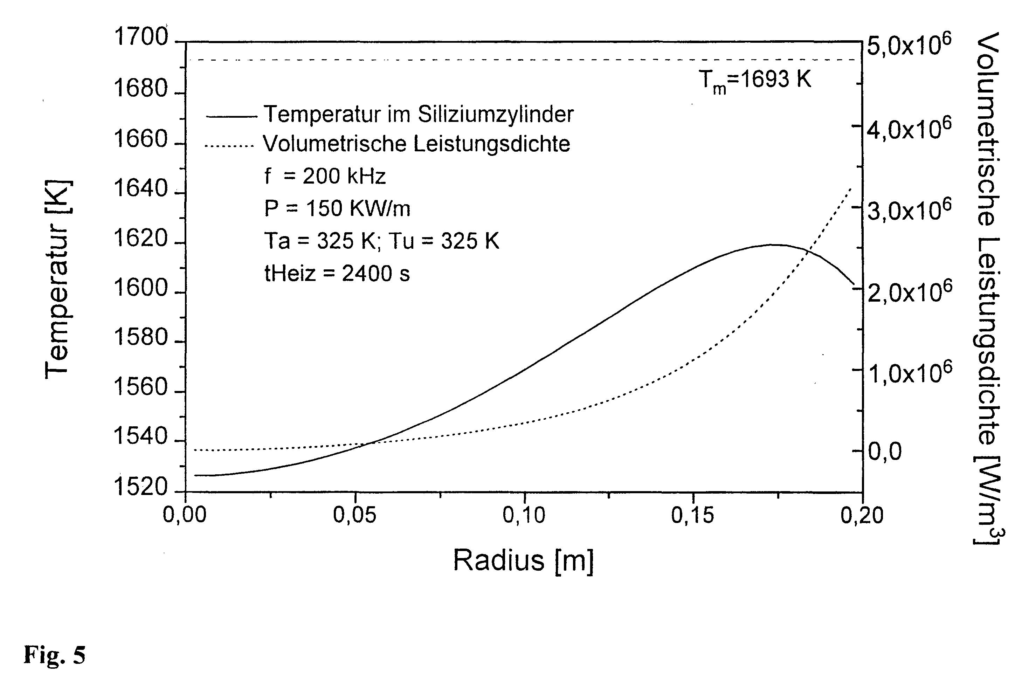

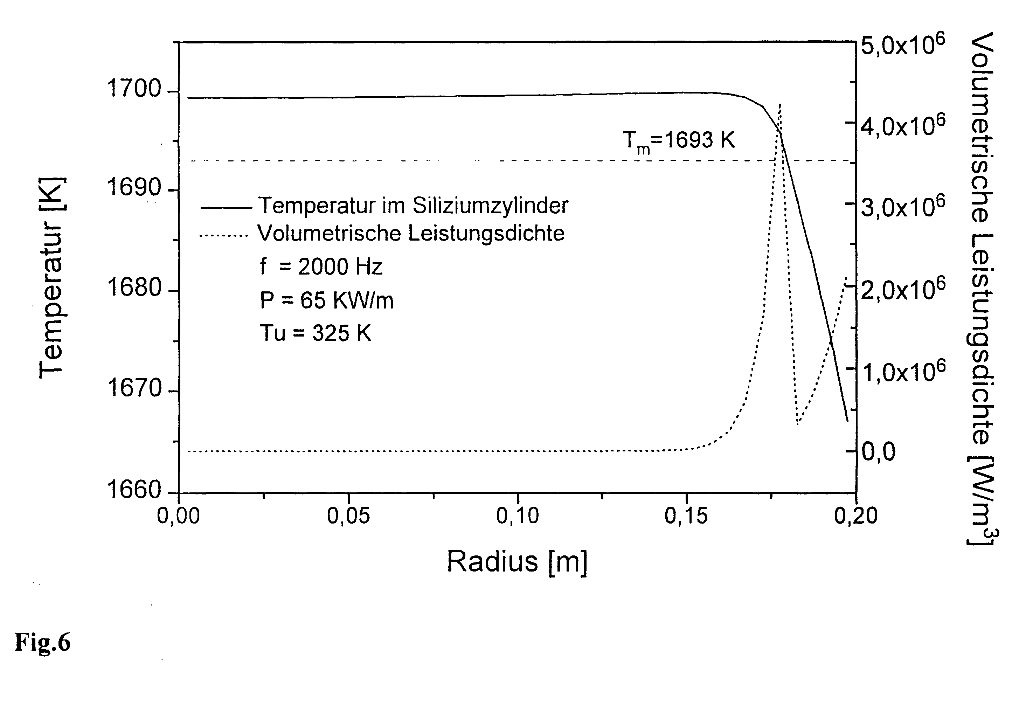

In den Figuren 5 und 6 sind die Ergebnisse der Berechnungen für die Aufheizphase und für den stationären Betrieb einer Siliziumschmelze in einem Rohling von 0,4 m Durchmesser dargestellt.

Entsprechend dieser Rechnungen wird in der Aufheizphase bei einer Frequenz von 200 KHz eine Leistung von 150 KW/m angelegt. Dabei bedeutet die Dimension KW/m die auf eine Prüflingslänge von 1 m bezogene absorbierte Leistung. Nachdem nach etwa 2400 s eine Temperatur in dem Festkörper erreicht ist, die etwa 100 K unter dem Schmelzpunkt von Silizium mit 1693 K liegt, wird die Frequenz von 200 KHz auf 2 KHz umgeschaltet und zunächst bei gleicher Leistung weitergeheizt, bis das Silizium im Innern zu schmelzen beginnt. Danach wird die Leistung auf den für den stationären Betrieb erforderlichen Wert (Fig. 6) von ca. 65 KW/m zurückgefahren.

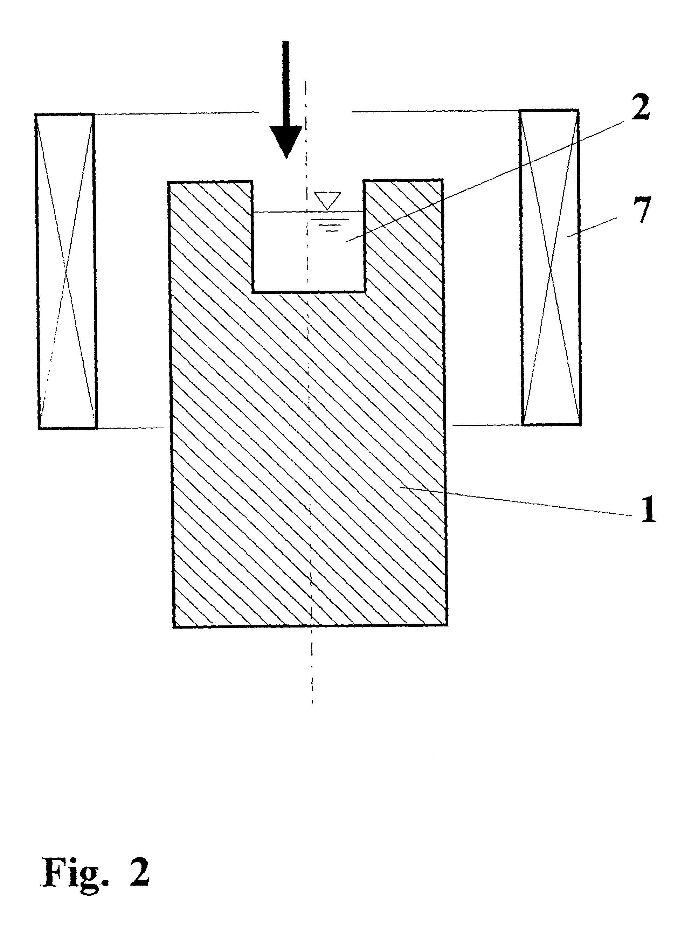

Eine weitere Aufheizmethode bzw. Startmethode ist in Fig. 2 gezeigt. In eine Vertiefung im Festkörper, Sinterkörper bzw. Preßling 1 wird Schmelze 2 des gleichen Materials bei anliegendem Induktionsfeld eingebracht. Die Schmelze 2 absorbiert wegen ihrer erhöhten Leitfähigkeit stärker als das nichterschmolzene Material. Von dieser Startschmelze 2 ausgehend kann der Körper bis auf eine verbleibende kalte Kruste aufgeschmolzen werden.

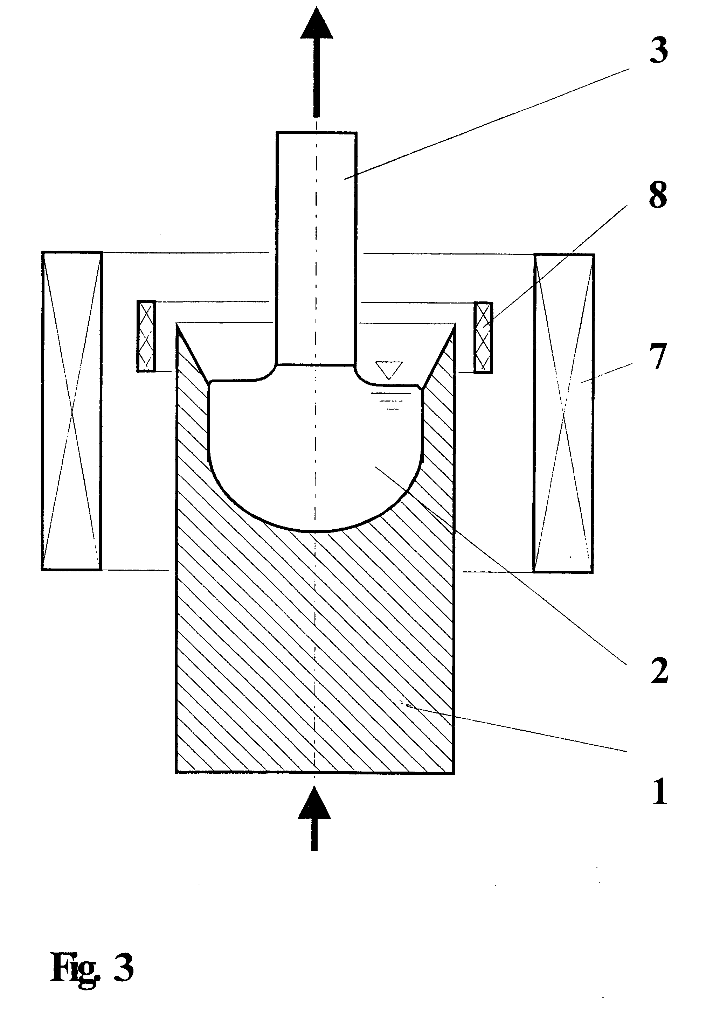

Zur Aufrechterhaltung einer Kruste muß von der Oberfläche der Kruste Wärme an die Umgebung abgeführt werden. Für das in Fig. 3 dargestellte Konzept kann diese Wärmeabfuhr nur über Wärmestrahlung erfolgen, da der Schmelz- und Ziehvorgang unter Vakuum bzw. unter sehr geringem Schutzgasdruck abläuft.

Diese Verlustwärme wird umso geringer je dicker die Kruste eingestellt wird.

Bei einem Durchmesser des Festkörpers von 0,4 m, einer Höhe des Schmelzbades von ebenfalls 0,4 m, einer Krustendicke von 2 cm sowie einer Ziehgeschwindigkeit von 5 cm/h wird eine induzierte Leistung von etwa 40 KW benötigt.

Durch Anbringen eines Wärmestrahlungsreflektors 8 aus elektrisch isolierendem Material im Bereich des oberen Krustenrandes wird erreicht, daß, wie in Fig. 3 schematisch dargestellt ist, die Kruste dort vollständig abschmilzt.

Mit diesem Verfahren läßt sich ein kontinuierlicher Betrieb beim Kristallziehen erreichen, indem wie in der Fig. 3 durch einen Pfeil angedeutet, von unten polykristallines Material nachgeschoben wird.

Die Wärmeverluste lassen sich drastisch reduzieren, wenn statt des polykristallinen Festkörpers ein Sinterkörper bzw. ein Preßling aus polykristallinem Material als Ausgangsmaterial verwendet wird.

Bei solchem Ausgangsmaterial ist die Wärmeleitfähigkeit gegenüber dem polykristallinen Festkörper stark reduziert.

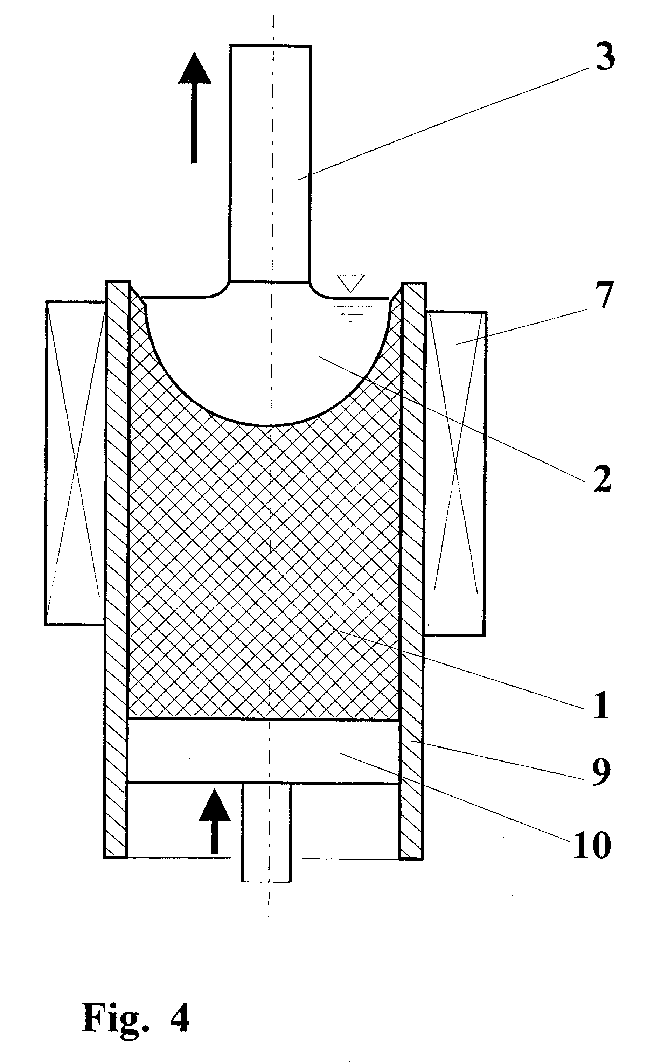

Bei diesem Konzept übernimmt, wie in Fig. 4 gezeigt, ein Führungsrohr 9 aus Quarz bzw. aus Sinterkeramik die Umschließung des Ausgangsmaterials. Ein Stempel 10 schiebt entsprechend dem Verbrauch an Schmelze das Ausgangsmaterial nach.

Der obere Rand der Kruste wird ähnlich wie in Fig. 3 gezeigt dadurch abgeschmolzen, daß dort die Kruste weniger intensiv gekühlt wird.

Bei diesem Konzept dient die Arbeitsspule 7 gleichzeitig zur Kühlung des Führungsrohres 9.

Das Verfahren gemäß Fig. 3 und Fig. 4 eignet sich besonders gut zum Erschmelzen von Ionenkristallen wie Alkalibromiden (NaBr, KBr,AgBr, CuBr), Alkalichloriden (LiCl, NaCl, KCl, CsCl, CaCl₂), Alkalifluoriden (LiF, NaF, KF), Alkalijodiden (NaJ, KJ), den Bromiden von Ag, Cu und Sb, den Chloriden von Ag, Cu und Mn und den Jodiden von Ag und Sb.

Bei diesen tritt bei Überschreiten des Schmelzpunktes eine große Erhöhung der elektrischen Leitfähigkeit und der Wärmeleitfähigkeit auf. Bei minimaler Wärmeabstrahlung kann mit geringer induktiver Heizleistung der Ziehvorgang aus der selbstgetiegelten Schmelze durchgeführt werden.

## Patentansprüche

1. Verfahren zum Ziehen von Einkristallen, wobei hochreines polykristallines Material mit Hilfe von Induktionsheizung geschmolzen und aus der erzeugten Schmelze der Einkristall gezogen wird, gekennzeichnet, durch folgende zusätzliche Verfahrensschritte,
a) Erhitzen mindestens eines Teiles des polykristallinen Materials in einer ersten Stufe zur Erhöhung der Leitfähigkeit mit direkter Induktionsheizung, wobei die Frequenz der Induktionsheizung größer ist als 200 kHz. und
b) Überführen des erhitzten Teiles des polykristallinen Materials mit direkter Induktionsheizung mit einer Frequenz kleiner als 20 kHz in eine Schmelze, wobei die Leistung und die Frequenz der Induktionsheizung so geführt wird, daß eine Randzone aus nicht geschmolzenem Material erhalten bleibt, die eine Selbsttiegelung darstellt, wobei als polykristallines Material Silicium oder Germanium verwendet wird

2. Verfahren nach Anspruch 1, dadurch gekennzeichnet, daß die Verringerung der Frequenz bei einer Temperatur etwa 100° unterhalb des Schmelzpunktes des polykristallinen Materials erfolgt.

3. Verfahren nach Anspruch 1 oder 2, dadurch gekennzeichnet, daß die Frequenz zum Überführen des erhitzten Teiles des polykristallinen Materials mit direkter Induktionsheizung 2 kHz beträgt, wobei als polykristallines Material Silicium verwendet wird.

## Claims

1. Method of growing monocrystals, wherein highly pure polycrystalline material is molten by means of induction heating, and the monocrystal is grown from the molten mass which is produced, characterised by the following additional method steps:
a) heating at least a portion of the polycrystalline material in a first stage to increase the conductivity with direct induction heating, the frequency of the induction heating being greater than 200 kHz, and
b) converting the heated portion of the polycrystalline material into a molten mass with direct induction heating at a frequency lower than 20 kHz, the power and the frequency of the induction heating being such that a marginal zone of non-molten material is retained, which zone represents a self-levelling zone, silicon or germanium being used as the polycrystalline material.

2. Method according to claim 1, characterised in that the reduction in the frequency is effected at a temperature substantially 100° below the melting point of the polycrystalline material.

3. Method according to claim 1 or 2, characterised in that the frequency for converting the heated portion of the polycrystalline material with direct induction heating is 2 kHz, silicon being used as the polycrystalline material.

## Revendications

1. Procédé pour tirer des monocristaux selon lequel on fait fondre une matière polycristalline extrêmement pure à l'aide d'un chauffage par induction et à partir du bain obtenu on tire le monocristal,
caractérisé par les étapes de procédé supplémentaires suivantes :
a) on chauffe au moins une partie de la matière polycristalline dans une première étape pour augmenter la conductivité avec chauffage direct par induction, la fréquence du chauffage par induction étant supérieure à 200 kHz et
b) on fait passer la partie chauffée de la matière polycristalline avec chauffage inductif direct sous une fréquence inférieure à 20 kHz dans un bain, la puissance et la fréquence du chauffage par induction étant conduites pour conserver une zone marginale de matière non fondue qui constitue un creuset automatique, et à partir de la matière polycristalline on utilise du silicium ou du germanium.

2. Procédé selon la revendication 1,
caractérisé en ce que
la réduction de la fréquence se fait à une température de l'ordre de 100° en dessous du point de fusion de la matière polycristalline.

3. Procédé selon l'une quelconque des revendications 1 ou 2,
caractérisé en ce que
la fréquence pour faire passer la troisième partie de la matière polycristalline avec chauffage inductif direct est de 2 kHz et comme matière polycristalline on utilise du silicium.
